## Europäisches Patentamt

## European Patent Office

## Office européen des brevets

(19)

(11) Veröffentlichungsnummer: **0 137 338**
**B1**

(12) **EUROPÄISCHE PATENTSCHRIFT**

(45) Veröffentlichungstag der Patentschrift:
**07.01.88**

(21) Anmeldenummer: **84110887.1**

(22) Anmeldetag: **12.09.84**

(51) Int. Cl.⁴: **G 01 P 5/00**

(51) Int. Cl.⁴: **G 01 P 5/00**

(54) Verfahren zur Messung von Strömungsgeschwindigkeiten mit Ultraschall.

(30) Priorität: **26.09.83 DE 3334819**

(43) Veröffentlichungstag der Anmeldung:
**17.04.85 Patentblatt 85/16**

(45) Bekanntmachung des Hinweises auf die Patenterteilung:
**07.01.88 Patentblatt 88/1**

(84) Benannte Vertragsstaaten:
**AT BE CH DE FR GB IT LI LU NL SE**

(56) Entgegenhaltungen:
**DE - A - 2 828 937**
**DE - A - 3 036 376**
**DE - A - 3 150 011**
**DE - A - 3 231 438**
**US - A - 3 751 979**

(73) Patentinhaber: **Siemens Aktiengesellschaft Berlin und München, Wittelsbacherplatz 2, D-8000 München 2 (DE)**

(72) Erfinder: **Stark, Reinhard, Dipl.-Ing. (FH), Wodanstrasse 20, D-8500 Nürnberg (DE)**

ACTORUM AG

## Beschreibung

Die Erfindung betrifft ein Verfahren zur Messung der Strömungsgeschwindigkeit eines flüssigen oder gasförmigen Mediums mit Ultraschall, mit einer zwischen zwei Ultraschallwandlern liegenden Messstrecke, die von dem Medium durchflossen ist, dessen Strömungsrichtung zumindest eine Komponente in Richtung der Messstrecke aufweist, wobei die beiden Ultraschallwandler zur Erzeugung zweier Ausbreitungsrichtungen des Ultraschalls periodisch abwechselnd als Sender und Empfänger betrieben werden, wobei der Ultraschall mit einem spannungsgesteuerten Oszillator, dem über eine Sendestufe ein Ultraschallwandler nachgeschaltet ist, erzeugt wird und seine Frequenz in beiden Ausbreitungsrichtungen mit einem Phasenregelkreis so geregelt wird, dass die Phasenlage des empfangenen Ultraschallsignals in beiden Ausbreitungsrichtungen gleich ist und wobei die Bestimmung der Strömungsgeschwindigkeit durch digitale Differenzbildung der beiden so erhaltenen Frequenzen erfolgt.

Ein Verfahren dieser Art ist aus der DE-A-28 28 937 bekannt. Dabei ist nicht näher ausgeführt, wie die Differenzbildung der beiden Frequenzen zur Bestimmung der Strömungsgeschwindigkeit erfolgt. Es ist lediglich angegeben, dass die Differenz beispielsweise mit einem Vorwärts-Rückwärts-Zähler gebildet wird.

Aufgabe der Erfindung ist es, ein Verfahren der eingangs genannten Art so auszugestalten, dass zu seiner Realisierung nur wenige Bauelemente erforderlich sind und dass der Energieverbrauch für die Messung gering bleibt.

Diese Aufgabe wird erfindungsgemäss dadurch gelöst, dass in jeder Ausbreitungsrichtung nach einer Ausregelzeit des Phasenregelkreises eine Abspeicherung des Steuersignals des Oszillators erfolgt, dass die Bestimmung der Strömungsgeschwindigkeit mit einer Rechenschaltung während einer anschliessenden Auswertezeit erfolgt und dass während der Auswertezeit die Sendestufe, der Empfänger für den Ultraschall und der Phasenregler von der Betriebsspannung getrennt werden und dass der Ausgang des Oszillators von der nachgeschalteten Sendestufe und der Steuereingang des Oszillators vom Phasenregler getrennt wird.

Dieses Verfahren lässt sich einfach realisieren, da das Weiterschwingen des Oszillators während der Auswertezeit eine einfache digitale Frequenzauswertung ermöglicht. Ausserdem wird auch der Stromverbrauch der Anordnung gering gehalten, da während der gegenüber der Ausregelzeit verhältnismässig langen Auswertezeit nur der eine geringe Leistung verbrauchende Oszillator in Betrieb ist.

Die Abspeicherung des Steuersignals kann auf einfache Weise mit einem dem Steuereingang des Oszillators parallel geschalteten Kondensator erfolgen.

Bei einer vorteilhaften Ausführungsform wird während jeder Auswerteperiode die Ausgangsfrequenz des Oszillators während einer festen Torzeit einem Zähler zugeführt, nach der Torzeit der Zählerstand mit den Takten eines Referenz-Taktgebers bis zu einem festen Wert hochgezählt und mit einer Recheneinheit die Differenz der dazu in beiden Ausbreitungsrichtungen erforderlichen Taktzahl gebildet. Die Differenzbildung kann dabei mit einem einfachen Zähler für eine Zählrichtung durchgeführt werden. Zur Übermittlung des Zählerstandes an die Recheneinheit ist nur eine einzige Verbindungsleitung und damit auch nur ein Eingangsport der Rechenschaltung erforderlich. Zähler für eine Zählrichtung sind mit deutlich geringerer Leistungsaufnahme erhältlich als Zweirichtungszähler, so dass auch diese Ausgestaltung dem Ziel einer geringen Energieaufnahme dient.

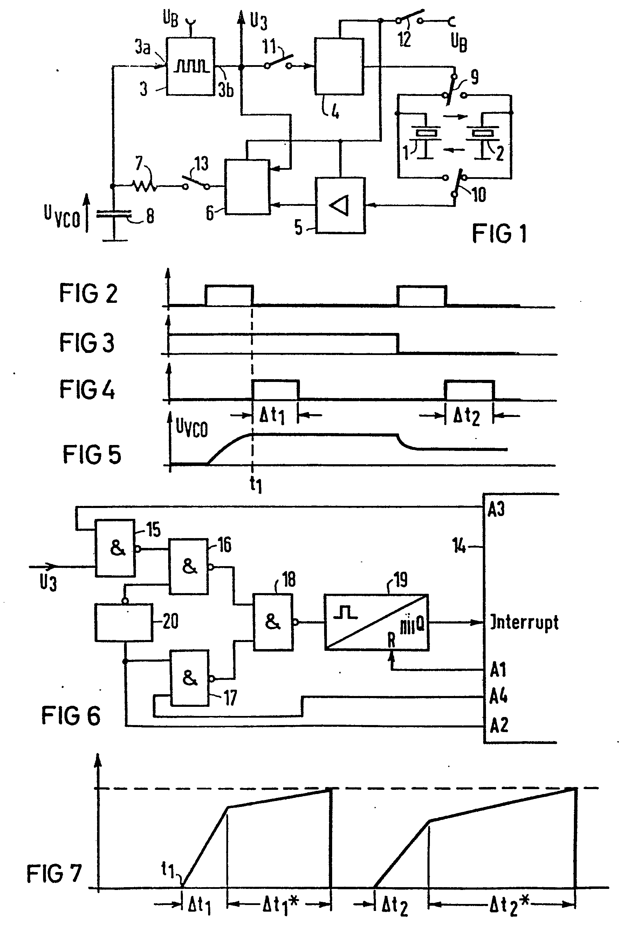

Ein Ausführungsbeispiel der Erfindung wird nachfolgend anhand der Figuren 1 bis 7 erläutert.

Dabei zeigt Fig. 1 das Blockschaltbild eines Messkreises für die Strömungsgeschwindigkeit ohne die zugehörige Auswerteschaltung. Die für die Ultraschallerzeugung erforderliche Frequenz wird von einem Oszillator 3 geliefert. Die Frequenz dieses Oszillators ist über einen Eingang 3a steuerbar. Der Ausgang 3b des Oszillators ist über einen Schalter 11 mit einer Sendestufe 4 verbunden, deren Spannungsversorgung durch die Betriebsspannung $U_B$ über einen Schalter 12 erfolgt. Der Ausgang der Sendestufe 4 ist über einen Umschalter 9 wahlweise mit einem Ultraschallwandler 1 oder 2 verbindbar. Über einen weiteren Umschalter 10 sind die Ultraschallwandler 1 und 2 ebenfalls wahlweise mit dem Eingang eines Empfangsverstärkers 5 verbindbar. Ein Phasenkomparator 6 weist zwei Eingänge auf, von denen einer mit dem Oszillator 3 und der andere mit dem Ausgang des Empfangsverstärkers 5 verbunden ist. Phasenkomparator 6 und Empfangsverstärker 5 werden ebenfalls über den Schalter 12 mit der Betriebsspannung $U_B$ versorgt. Der Ausgang des Phasenkomparators 6 ist über einen Schalter 13 und einen Widerstand 7 mit dem Steuereingang 3a des Oszillators 3 verbunden. Zwischen Steuereingang 3a und Bezugspotential der Schaltung ist ein Kondensator 8 angeordnet. Der Phasenkomparator 6 wirkt bei dieser Schaltung als Proportionalregler.

Die Funktion dieser Schaltung wird nachfolgend anhand der Figuren 2 bis 5 für eine Messperiode dargestellt.

Fig. 2 zeigt den Schaltzustand der Schalter 11 bis 13, wobei ein «1»-Signal bedeutet, dass diese Schalter geschlossen sind. Zu Beginn jeder Messperiode werden also die Sendestufe 4, der Empfangsverstärker 5 und der Phasenkomparator 6 mit Betriebsspannung versorgt. Die Umschalter 9 und 10 sollen beispielsweise in der eingezeichneten Stellung stehen. Der Ultraschallwandler 1 wandelt die vom Oszillator 3 erzeugte und von der Sendestufe 4 verstärkte Impulsfolge in Ultraschallschwingungen um und arbeitet somit als Sender. Die erzeugten Ultraschallschwingungen werden über das nicht dargestellte Medium, dessen Strömungsgeschwindigkeit bestimmt werden soll, zu dem in diesem Fall als Empfänger arbeitenden Ultraschallwandler 2 übertragen. Die vom Ultraschallwandler 2 empfangenen Ultraschallschwingungen werden mit dem Empfängerverstärker 5 verstärkt. Die so erhaltene Impulsfolge wird im Phasenkomparator 6 mit der ursprünglichen, vom Oszillator 3 direkt gelieferten Impulsfolge verglichen. Die Frequenz des Oszillators 3 wird von der Ausgangsspannung des Phasenkomparators so geregelt, dass die Phasenabweichung zwischen den beiden Impulsfolgen Null wird. Wie in der bereits eingangs genannten DE-OS 28 28 937 erläutert, ist nämlich die Ultraschallwellenlänge von der zur Ultraschallmessstrecke parallelen Komponente der Strömungsgeschwindigkeit abhängig. Durch den Phasenregelkreis mit dem Phasenkomparator 6 und dem Oszillator 3 (Phase locked loop-PLL) wird erreicht, dass in die Ultraschallmessstrecke eine feste Anzahl von Ultraschallwellenzügen passt.

Beim Regelvorgang stellt sich die in Fig. 5 dargestellte Steuerspannung $U_{VCO}$ auf einen bestimmten Wert ein, der gerade der passenden Frequenz entspricht. Diese Spannung wird mit dem Kondensator 8 gespeichert.

Nach Ablauf einer Ausregelzeit des Phasenregelkreises werden zum Zeitpunkt $t_1$ die Schalter 11 bis 13 geöffnet, wie in Fig. 1 sichtbar ist. Der Oszillator 3 schwingt nun wegen der Abspeicherung seiner Steuerspannung genau mit der Frequenz weiter, die während der Ausregelzeit ermittelt wurde. Diese Frequenz kann nun während einer Auswertezeit $\Delta t_1$, $\Delta t_1^*$ in einer noch zu erläuternden Auswerteschaltung bestimmt werden. Während der Auswertezeit $\Delta t_1$, $\Delta t_1^*$ bleibt der Stromverbrauch der dargestellten Schaltung gering, da nur der einen geringen Leistungsbedarf aufweisende Oszillator 3 in Betrieb bleibt. Insbesondere ist der grösste Leistungsverbraucher der Schaltung, nämlich die Sendestufe 4, ausgeschaltet.

Nach Ablauf der Auswertezeit $\Delta t_1$, $\Delta t_1^*$ werden die Umschalter 9 und 10 in ihre andere Stellung gebracht, so dass der Ultraschallwandler 2 nunmehr als Sender und der Ultraschallwandler 1 als Empfänger arbeitet. Die Stellung der Umschalter 9, 10 und damit die Ausbreitungsrichtung ist in Fig. 3 dargestellt. Ausserdem werden die Schalter 11 und 13 wieder eingeschaltet. Da sich nunmehr die Ausbreitungsrichtung des Ultraschalls bezüglich der Strömungsrichtung des Mediums umgekehrt hat, wird die Frequenz des Oszillators 3 wieder solange geändert, bis die Phasenabweichung zwischen Ausgangsspannung des Oszillators 3 und Ausgangsspannung des Ultraschallwandlers 2 wieder Null ist. Nach einer Ausregelzeit hat sich die dafür erforderliche Steuerspannung $U_{VCO}$ eingestellt und zum Zeitpunkt $t_1$ folgt eine zweite Auswertezeit $\Delta t_2$, $\Delta t_2^*$, in der mit einer Auswerteschaltung die zweite Frequenz bestimmt wird. Auch während der zweiten Auswertezeit $\Delta t_2$, $\Delta t_2^*$ werden die Schalter 11 bis 13 ausgeschaltet.

Die Energieaufnahme der gesamten Schaltung bleibt also gering, da die Baugruppen mit der grössten Leistungsaufnahme, insbesondere die Sendestufe während des grössten Teiles einer Messperiode ausgeschaltet sind.

Ein Ausführungsbeispiel für die Auswertung der so gewonnenen Frequenzen wird nachfolgend anhand der Fig. 6 zusammen mit dem Diagramm nach Fig. 7 erläutert.

Die Ausgangsspannung $U_3$ des Oszillators 3 wird einem Eingang eines Nand-Gatters 15 zugeführt, dessen zweiter Eingang vom Ausgang A3 eines Mikroprozessors 14 gesteuert wird. Der Ausgang des Nand-Gatters 15 ist mit einem Eingang eines zweiten Nand-Gatters 16 verbunden, dessen zweiter Eingang über einen Inverter 20 ebenfalls von einem Ausgang A2 des Mikroprozessors 14 gesteuert wird. Der Ausgang des Nand-Gatters 16 ist wiederum mit einem Eingang des Nand-Gatters 18 verbunden, dem ausgangsseitig ein Zähler 19 nachgeschaltet ist. Ein weiteres Nand-Gatter 17 ist eingangsseitig mit dem Ausgang A2 des Mikroprozessors 16 und mit einem Taktausgang A4 verbunden. Ausgangsseitig ist das Nand-Gatter 17 mit einem zweiten Eingang des Nand-Gatters 18 verbunden. Der Zähler 19 weist einen Reset-Eingang auf, der von einem Ausgang A1 des Mikroprozessors angesteuert wird. Ferner hat der Zähler einen Ausgang, der bei einem vorgegebenen Zählerstand Q auf «1» geht.

Die Auswerteschaltung wird mit dem Mikroprozessor 14 nach einem im folgenden anhand von Fig. 7 erläuterten Verfahren gesteuert. Zu Beginn der Messperiode wird der Zähler 19 durch ein «1»-Signal am Ausgang A1 des Mikroprozessors zurückgesetzt. Anschliessend erscheint am Ausgang A3 ein «1»-Impuls von definierter Dauer $\Delta t_1$. Damit werden die Ausgangsimpulse des Oszillators 3 freigegeben und in den Zähler 19 eingezählt. Eine direkte Erfassung dieser Impulse mit dem Mikroprozessor 14 ist nicht möglich, da dessen Verarbeitungsgeschwindigkeit zu gering ist. Der während der konstanten Zeitspanne $\Delta t_1$ erreichte Zählerstand ist der Frequenz des Oszillators 3 proportional. Anschliessend werden für eine variable Zeitspanne $\Delta t_1^*$ die Impulse des Oszillators 3 gesperrt und durch ein «1»-Signal am Ausgang A2 des Mikroprozessors 14 die an seinem Ausgang A4 anstehenden Taktimpulse freigegeben und in den Zähler 19 eingezählt. Die Frequenz dieser Taktimpulse ist an die Verarbeitungsgeschwindigkeit des Mikroprozessors 14 angepasst. Wenn der Zähler 19 einen vorgegebenen Zählerstand Q erreicht hat, wird der Zählvorgang unterbrochen und die während der Zeitspanne $\Delta t_1^*$ vom Mikroprozessor 14 abgegebenen Impulse in diesem gespeichert. Damit steht also im Mikroprozessor 14 ein Wert zur Verfügung, der der Differenz der vorgegebenen Impulszahl Q und der Zahl der während der Zeitspanne $\Delta t_1$ abgegebenen Impulse entspricht. Die vorgegebene Zahl Q ist so gewählt, dass sie während der Zeitspanne $\Delta t_1$ mit Sicherheit nicht erreicht wird. Anschliessend erfolgt derselbe Auswertevorgang für die zweite Ausbreitungsrichtung des Ultraschalls. Dabei werden während einer festen Zeitspanne $\Delta t_2$ die vom Oszillator 3 gelieferten Impulse gezählt und während einer va-

riablen Zeitspanne $\Delta t_2{}^*$ der Zählerstand auf den Wert Q hochgezählt. Die zum Hochzählen erforderlichen Impulse werden wiederum im Mikroprozessor erfasst. Der Mikroprozessor 14 bildet anschliessend die Differenz der während der Zeitspannen $\Delta t_1{}^*$ und $\Delta t_2{}^*$ abgegebenen Impulse. Diese Differenz ist der Differenzfrequenz bei beiden Ausbreitungsrichtungen des Ultraschalls proportional und damit ein Mass für die Strömungsgeschwindigkeit.

Die dargestellte Auswertung hat den Vorteil, dass zur Ermittlung des Zählerstandes nach den Zeitspannen $\Delta t_1$ und $\Delta t_2$ nur eine einzige Verbindung zwischen Zählerausgang und Mikroprozessor, d.h. nur ein Eingangsport des Mikroprozessors 14 erforderlich ist. Ein üblicher Binärzähler mit paralleler Zählerstandserfassung würde eine grosse Anzahl von Eingangsports des Mikroprozessors 14 belegen. Gegenüber der Verwendung von Vor-/Rückwärtszählern hat die dargestellte Anordnung den Vorteil, dass Zähler für eine Zählrichtung mit grösseren Kapazitäten lieferbar sind. Zur Erreichung einer hohen Auflösung muss die Auswertezeit, die sich aus den Zeitspannen $\Delta t_1$, $\Delta t_1{}^*$, $\Delta t_2$, $\Delta t_2{}^*$ zusammensetzt, vor allem wegen der relativ kleinen Verarbeitungsgeschwindigkeit des Mikroprozessors 14 verhältnismässig lang gewählt werden. Dies wirkt sich auf die Energieaufnahme des Gerätes kaum aus, da während der Auswertezeit — wie erläutert — die Bausteine mit der grössten Leistungsaufnahme ausgeschaltet sind.

**Patentansprüche**

1. Verfahren zur Messung der Strömungsgeschwindigkeit eines flüssigen oder gasförmigen Mediums mit Ultraschall, mit einer zwischen zwei Ultraschallwandlern (1, 2) liegenden Messstrecke, die von dem Medium durchflossen ist, dessen Strömungsrichtung zumindest eine Komponente in Richtung der Messstrecke aufweist, wobei die beiden Ultraschallwandler (1, 2) zur Erzeugung zweier Ausbreitungsrichtungen des Ultraschalls periodisch abwechselnd als Sender und Empfänger betrieben werden, wobei der Ultraschall mit einem spannungsgesteuerten Oszillator (3), dem über eine Sendestufe (4) ein Ultraschallwandler (1, 2) nachgeschaltet ist, erzeugt wird und seine Frequenz in beiden Ausbreitungsrichtungen mit einem Phasenregelkreis so geregelt wird, dass die Phasenlage des empfangenen Ultraschallsignals in beiden Ausbreitungsrichtungen gleich ist und wobei die Bestimmung der Strömungsgeschwindigkeit durch digitale Differenzbildung der beiden so erhaltenen Frequenzen erfolgt, dadurch gekennzeichnet, dass in jeder Ausbreitungsrichtung nach einer Ausregelzeit des Phasenregelkreises eine Abspeicherung des Steuersignals des Oszillators (3) erfolgt, dass die Bestimmung der Strömungsgeschwindigkeit mit einer Rechenschaltung während einer anschliessenden Auswertezeit ($\Delta t_1$, $\Delta t_1{}^*$, $\Delta t_2$, $\Delta t_2{}^*$) erfolgt, und dass während der Auswertezeit die Sendestufe (4), der Empfänger (5) für den Ultraschall und der Phasenregler (6) von der Betriebsspannung getrennt werden und dass der Ausgang des Oszillators (3) von der nachgeschalteten Sendestufe (4) und der Steuereingang des Oszillators (3) vom Phasenregler (6) getrennt wird.

2. Verfahren nach Anspruch 1, dadurch gekennzeichnet, dass die Abspeicherung des Steuersignals mit einem dem Steuereingang des Oszillators (3) parallel geschalteten Kondensator (8) erfolgt.

3. Verfahren nach Anspruch 1 oder 2, dadurch gekennzeichnet, dass während jeder Auswerteperiode die Ausgangsfrequenz des Oszillators (3) während einer festen Torzeit ($\Delta t_1$, $\Delta t_2$) einem Zähler (19) zugeführt wird, dass nach der Torzeit ($\Delta t_1$, $\Delta t_2$) der Zählerstand mit den Takten eines Referenz-Taktgebers bis zu einem festen Wert (Q) hochgezählt wird und dass mit einer Recheneinheit (14) die Differenz der dazu in beiden Ausbreitungsrichtungen erforderlichen Taktzahlen gebildet wird.

**Revendications**

1. Procédé de mesure de la vitesse d'écoulement d'un milieu liquide ou gazeux par ultrasons, utilisant un trajet de mesure situé entre deux transducteurs ultrasonores (1, 2) et traversé par le milieu dont la direction d'écoulement présente au moins une composante dans le sens du trajet de mesure, procédé dans lequel on fait fonctionner les deux transducteurs ultrasonores (1, 2) de façon périodiquement alternée comme émetteur et comme récepteur pour la création de deux directions de propagation des ultrasons, dans lequel on produit les ultrasons au moyen d'un oscillateur (3) commandé par tension et qui est suivi, avec interposition d'un étage d'émission (4), par un transducteur ultrasonore (1, 2), et on règle la fréquence des ultrasons dans les deux directions de propagation par un circuit de régulation de phase, de manière que la position de phase du signal ultrasonore reçu soit la même dans les deux directions de propagation, et dans lequel on détermine la vitesse d'écoulement par la formation numérique de la différence des deux fréquences ainsi obtenues, caractérisé en ce que, pour chaque direction de propagation, après un temps de régulation du circuit de régulation de phase, on mémorise le signal de commande de l'oscillateur (3), on détermine la vitesse d'écoulement par un circuit de calcul pendant un temps d'exploitation ($\Delta t_1$, $\Delta t_1{}^*$, $\Delta t_2$, $\Delta t_2{}^*$) consécutif, on coupe, pendant le temps d'exploitation, l'étage d'émission (4), le récepteur (5) pour les ultrasons et le régulateur de phase (6) de la tension de service, on coupe la sortie de l'oscillateur (3) de l'étage d'émission (4) monté à sa suite et on coupe l'entrée de commande de l'oscillateur (3) du régulateur de phase (6).

2. Procédé selon la revendication 1, caractérisé en ce que l'on mémorise le signal de commande au moyen d'un condensateur (8) monté en parallèle avec l'entrée de commande de l'oscillateur (3).

3. Procédé selon la revendication 1 ou 2, caractérisé en ce que, pendant chaque période d'exploitation, on applique la fréquence de sortie de l'oscillateur (3) pendant un temps de comptage

fixe ($\Delta t_1$, $\Delta t_2$) à un compteur (19); après le temps de comptage ($\Delta t_1$, $\Delta t_2$), on fait progresser la position du compteur par les impulsions d'horloge d'une horloge de référence, jusqu'à une valeur fixe ($Q$), et, par une unité de calcul (14), on forme la différence des nombres d'impulsions d'horloge nécessaires à cet effet dans les deux directions de propagation.

## Claims

1. A method of measuring the rate of flow of a liquid or gaseous medium using ultrasonics, with a measuring section located between two ultrasonic transducers (1, 2) and traversed by the medium whose flow direction includes at least one component in the direction of the measuring section, where the two ultrasonic transducers (1, 2) are periodically operated alternately as transmitter and receiver in order to produce two ultrasonic propagation directions, where the ultrasonic radiation is produced by a voltage-controlled oscillator (3) whose output is connected via a transmitting stage (4) to an ultrasonic transducer (1, 2), and whose frequency is regulated in both propagation directions by a phase-regulating circuit such that the phase position of the received ultrasonic signal is identical in both propagation directions, and the rate of flow is determined by digital analysis of the difference between the two frequencies obtained in this way, characterised in that in each propagation direction, following a settling time of the phase-regulating circuit, the control signal of the oscillator (3) is stored, that the rate of flow is determined by a calculating circuit during a following analysis time ($\Delta t_1$, $\Delta t_1^*$, $\Delta t_2$, $\Delta t_2^*$), and that during the analysis time the transmitting stage (4), the receiver (5) for ultrasonic radiation, and the phase regulator (6) are cut off from the operating voltage, the output of the oscillator (3) is cut off from the following transmitting stage (4), and the control input of the oscillator (3) is cut off from the phase regulator (6).

2. A method as claimed in Claim 1, characterised in that the control signal is stored by means of a capacitor (8) connected parallel to the control input of the oscillator (3).

3. A method as claimed in Claim 1 or 2, characterised in that in each analysis period the output frequency of the oscillator circuit (3) is supplied to a counter (19) during a fixed gate time ($\Delta t_1$, $\Delta t_2$), that following the gate time ($\Delta t_1$, $\Delta t_2$) the count is increased by the clock pulses of a reference clock generator up to a fixed value ($Q$), and that a calculating unit (14) forms the difference between the number of clock pulses required for this purpose in the two propagation directions.

0 137 338

1/1

FIG 1

FIG 2

FIG 3

FIG 4

FIG 5

FIG 6

FIG 7

7